# EUROPEAN PATENT APPLICATION

(11) **EP 1 326 330 A1**
(43) Date of publication of application: **09.07.2003**
(21) Application number: 01130995.2
(22) Date of filing: 28.12.2001
(51) Int. Cl.: H03G 3/30

(54) **RF output power control for mobile phones**

(71) Applicant: Sony International (Europe) GmbH, 10785 Berlin (DE)
(72) Inventor: Isaksen, Jörn, 85609 Aschheim-Dornach (DE)
(74) Representative: Körber, Martin, Dipl.-Phys.

(57) **Abstract**

The present invention provides a power controlled high-frequency transmit power amplifier circuit (10) for a mobile communication device of a wireless communication system, and a mobile terminal for wireless telecommunication systems comprising that power controlled high-frequency transmit power amplifier circuit (10) with a high-frequency power amplifier (11) for amplifying an input power signal into an output power signal with a control terminal for controlling the high-frequency output power (Pₒᵤₜ) of the same, a detection means (14) connected to an input line supplying the input power signal to the power amplifier (11) for detecting a value related to an actual value of the high-frequency output power (Pₒᵤₜ) by measuring a value associated with the input impedance of the power amplifier (11), and for providing a signal (Vₐₚ) indicative of the actual value of the high-frequency output power (Pₒᵤₜ), and a control means (15) comparing a reference signal (T_{XP}) indicative of a target value of the output power (Pₒᵤₜ) to the signal (Vₐₚ) indicative of an actual value of the output power (Pₒᵤₜ) and providing a control signal (V_{apc}) to the control terminal of the power amplifier (11) for adjusting the high-frequency output power (Pₒᵤₜ) of the same

## Description

The present invention relates to a high-frequency (RF) transmit power amplifier used in mobile terminals for wireless telecommunication systems, in particular to a high-frequency transmit power amplifier with a control of its RF output power.

Conventional mobile terminals for wireless telecommunication systems like e.g. the GSM/GPRS or the UMTS system, usually comprise a closed loop power control circuit for controlling the output power of a high-frequency transmit power amplifier. An adaptive transmission power control is necessary for third generation mobile communication systems in order to resolve the so-called "near-far-problem". The problem arises e.g. when mobile terminals communicate using the CDMA- (Code Division Multiple Access) technology where the same frequencies are employed for all users. If all mobile terminals would transmit at the same high power levels, regardless of their distance from the base station, then the high field strength of the radio waves emitted from a nearby mobile terminal would make it impossible to separate signals from more distant mobile terminals. An adaptive transmission power control is further also effective in suppressing interference to low levels, thereby contributing to an increase of the subscriber capacity of a wireless network system. Furthermore, a control of the output power of the power amplifier is necessary, due to unavoidable frequency and temperature-dependent variations of the characteristics of the amplifier's components.

JP8222973 discloses a control of the output power of a RF power amplifier circuit by a voltage controlled impedance matching circuit preceding the input terminal of the power amplifier. The RF output power is hereby modified by modifying the reflection losses of the RF input signal by means of a voltage variable element used in the impedance matching circuit. The suggested attenuation of the input signal for reducing the RF output power instead of controlling the amplifiers gain results in a bad signal-to-noise ratio when applied to a large power range, and is therefore not applicable to a power control of mobile communication systems.

The power amplifier circuits used in present-day mobile terminals provide a so-called "Vapc"-terminal to which a control voltage V_{apc} can be applied for manipulating or controlling the RF output power of the power amplifier circuit. The abbreviation "Vapc" stands for voltage automated power control which is somewhat misleading, because no absolute value of the output power can be adjusted. For an exact control of the RF output power a signal indicative of the actual RF output power value, in the following referred to as actual-power-signal has to be derived from the amplifier circuit and processed in a closed-loop control.

Currently, such an actual-power-signal is either being derived from a decoupled part of the power amplifier RF output, i.e. measured or detected between the power amplifier RF output terminal and a transmission antenna, or is being derived from a value indicative of the power amplifiers power consumption, i.e. measured or detected between a power supply terminal of the power amplifier and a battery or at the battery. Both values are generally seen at as a measure for the RF power provided at the amplifiers output.

In the first case, the actual-power-signal formed by converting the decoupled part of the RF output into a DC-value is compared to a reference voltage indicative of the target RF output power provided by a digital control circuit of the mobile terminal. A control voltage corresponding to the difference between the actual-power-signal and the reference voltage is then applied to the "Vapc"-terminal to readjust the RF output power of the power amplifier. The additional component necessary for decoupling a respective part of the RF output signal inevitably results in an attenuation of the RF power on disposition.

In the second case the fact is used that the power amplifier circuits are carried out as multi stage amplifiers wherein the last stage practically consumes all of the supplied energy. As the power consumption of the last stage is indicative of the achieved RF output power, the supply current to the amplifier circuit provides a reliable means for monitoring the RF output power of a power amplifier. Usually, a resistor of small value is placed between the energy source and the supply voltage terminal of the power amplifier for monitoring the supply current. The voltage drop over this resistor is used as an actual-power-signal from which an appropriate control voltage is generated by comparison with a voltage reference like described above. Unfortunately, the voltage drop across the resistor reduces the supply voltage being applied to the power amplifier which results in a considerable reduction of the RF output power achievable.

Energy sources available in mobile terminals are typically battery packs providing a very limited energy resource. The increased energy consumption associated with the above described methods for an output power control has therefore to be seen as a major drawback as it considerably reduces the potential talk time.

It is therefore an object of the present invention, to provide a RF power amplifier for use in mobile terminals for wireless telecommunication systems which output power can be controlled based on a verification of the actual output power with the verification not causing any reduction in the achievable RF output power nor increasing the overall power consumption.

This object is achieved by a power controlled high-frequency transmit power amplifier circuit for a mobile communication device of a wireless communication system, comprising a high-frequency power amplifier for amplifying an input power signal into an output power signal with a control terminal for controlling the high-frequency output power of the same, a detection means connected to an input line supplying the input power signal to the power amplifier for detecting a value related to an actual value of the high-frequency output power by measuring a value associated with the input impedance of the power amplifier, and for providing a signal indicative of the actual value of the high-frequency output power, and a control means comparing a reference signal indicative of a target value of the high-frequency output power to the signal indicative of an actual value of the high-frequency output power, and providing a control signal to the control terminal of the power amplifier for adjusting the high-frequency output power of the same.

The above object is further achieved by a mobile terminal for wireless telecommunication systems comprising a power controlled high-frequency transmit power amplifier circuit according to the present invention.

The present invention takes advantage of the fact that the input impedance of a present-day high-frequency power amplifier varies with the high-frequency power provided at the amplifiers output. The impact of this variation of the input impedance on the behaviour of the high-frequency input signal is advantageously used to form a measure for the high-frequency output power of the power amplifier without reducing, disturbing or negatively influencing the achievable RF output power.

Further advantageous features are claimed in the respective sub-claims.

The consequence of a varying input impedance is a corresponding variation in the value of the mismatch between the input of the power amplifier and the feed-in line. The mismatch causes a reflection of a portion of the high-frequency signal applied to the input of the power amplifier, whereby the value of the reflected portion is a measure for the input impedance. In a preferred embodiment of the present invention, the value of the reflected portion of the power of a high-frequency signal applied to the input of the power amplifier therefore forms the value associated with the input impedance used to provide a signal indicative of the actual value of the output power.

The signal indicative of an actual value of the output power is preferably a DC-like voltage or DC-like current allowing a simple and cost-effective design of a power controlled high-frequency power amplifier circuit.

The power controlled high-frequency transmit power amplifier circuit according to the present invention serves for an accurate control of the RF power emitted from a wireless telecommunication device. e.g. a mobile phone, a cordless phone or the like according to a target value supplied from a transmission control component of that device.

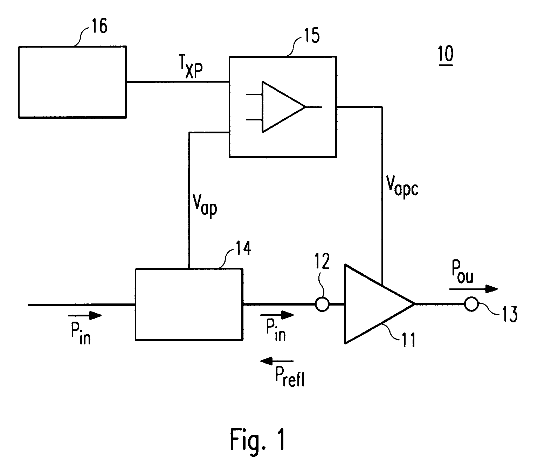

In the following, the present invention will be explained in detail and by way of example only, with reference to the attached single Figure 1 showing a schematic block diagram of a power controlled high-frequency transmit power amplifier circuit designated by 10.

The power control circuit 10 shown in Fig. 1 serves for controlling the high-frequency output power Pₒᵤₜ of the power amplifier 11. A control of the output power Pₒᵤₜ is essential for mobile terminals used in wireless communication systems such as systems according to the GSM or the UMTS standard.

The power amplifier 11 used in the control circuit 10 receives a RF signal having a power Pᵢₙ at its input terminal 12 and delivers an output signal at its output 13 to an antenna (not shown in Fig. 1) for being transmitted therefrom. The output signal of power Pₒᵤₜ is an amplified version of the input signal. The amplification of the power amplifier 11 is controlled by a control signal V_{apc} when applied to a particular port of the amplifier device 11 which is internally connected to a unit for manipulating the RF output power Pₒᵤₜ. The control signal V_{apc} hereby rather affects the output power Pₒᵤₜ than the gain of the amplifier 11.

It is to be noted, that only components necessary for the understanding of the present invention are shown in Fig. 1. A representation of other components like for instance a power supply, a transmission control or the like which are necessary for the operation of the power control circuit but show no reference to the principle underlying the present invention are omitted for the sake of clarity.

The power control circuit is designed as a closed-loop control circuit. The control operation is shared between two units. A first unit 14 is responsible for providing a "feedback" signal Vₐₚ indicative of the actual RF output power Pₒᵤₜ delivered by the power amplifier 11. The second unit 15 processes this signal Vₐₚ with respect to a reference signal T_{XP} for providing a control signal V_{apc} used to manipulate the RF output power Pₒᵤₜ of the power amplifier 11. As distinguished from classic closed-loop designs, the "feedback" signal Vₐₚ is not taken from the output signal of the power control circuit but from a signal generated within the circuit.

Power amplifiers 11 used in present-day RF output stages for mobile terminals show an input impedance varying with the signal power Pₒᵤₜ delivered at their output 13. The input impedance usually matches the impedance of the feed-in line supplying the RF input signal to the power amplifier 11 at maximum RF power output. The impedance of the feed-in line has, e.g. a typical value of 50 Ω. Operating the power amplifier 11 below its maximum RF output power therefore results in a mismatch between the input impedance of the power amplifier and the feed-in line impedance. The mismatch will be more significant for lower RF output powers Pₒᵤₜ than for higher.

Due to the mismatch, a part of the power Pᵢₙ of the input RF signal will be reflected at the interface between the feed-in line and the input 12 of the power amplifier 11. The power P_{refl} of the reflected portion of the input RF signal is directly related to the mismatch in the impedances of the feed-in line and the input terminal 12 of the amplifier. As the feed-in line has an impedance of constant value, the reflected power signal is therefore directly related to the value of the input impedance, and through this to the actual value of the RF output power Pₒᵤₜ of the power amplifier 11. Yet, there is an inverted relationship between the RF output power Pₒᵤₜ and the reflected power P_{refl} as the reflected power P_{refl} increases when the output power Pₒᵤₜ decreases and vice versa.

That some of the RF input signal power Pᵢₙ is reflected at the input 12 of the power amplifier 11 does not mean, the there is an attenuation of RF power resulting in a reduction of a respective RF output power Pₒᵤₜ. A power amplifier 11 used for transmission of signals in wireless communication systems typically operates in a saturation mode. In this mode a power amplifier is tolerant to variations of the input RF power Pᵢₙ, which means that variations of the input power Pᵢₙ within a range of a small fraction of a dB (decibel) will not affect the output power Pₒᵤₜ.

The evaluation of the power level P_{refl} and the according generation of the "feedback" signal Vₐₚ is accomplished by the detection unit 14. The respective conversion can either be realised based on a hardwired analogue electronic circuit or based on digital circuitry using a conversion algorithm. The "feedback" signal Vₐₚ is preferably a DC-like signal, e.g. a voltage or a current which absolute value corresponds to the power level P_{refl} of the reflected portion of the input signal. But Vₐₚ can for instance also be implemented as a frequency coded signal where the frequency value is indicative of the actual value of the output power Pₒᵤₜ or any other suitable coded signals. Although the detection unit 14 adds a small attenuation to the power Pᵢₙ of the input RF signal, the introduced attenuation value is too small to cause a reduction of the RF output power Pₒᵤₜ, as has been explained above in more detail.

The control unit (15) provides a power control signal V_{apc} to the port of the power amplifier 11 allowing a manipulation of the RF output power Pₒᵤₜ of the same. The value of the control signal V_{apc} is derived from a comparison of the "feedback" signal Vₐₚ with the reference signal T_{XP} which is indicative of a target value of the output power Pₒᵤₜ. Like the "feedback" signal, the reference signal may be formed by a DC-like entity, a frequency coded signal or another suitable form of coded signal. When using a DC-like voltage for a control signal V_{apc}, then it may e.g. be formed by an operational amplifier wired as a subtractor or as an adder circuit.

The reference signal T_{XP} is formed by a reference signal forming unit 16 which is part of a central transmission control component (not shown in Fig. 1) of the mobile terminal, and which pre-sets a target value for Pₒᵤₜ, e.g. 0.1 W, 0.2 W, 0.5 W or the like. The target value of Pₒᵤₜ may vary according to output power settings specified from a connected base station of the wireless telecommunication system. The reference signal forming unit 16 then generates a reference signal based on the specification received for Pₒᵤₜ from the base station.

Different from a conventional closed-loop control circuit, the present invention uses an entity obtained at the input of the power amplifier 11 as a "feedback" signal, so that the feedback loop causes no disadvantageous effect on the value of the respective RF output power Pₒᵤₜ.

## Claims

1. A power controlled high-frequency transmit power amplifier circuit for a mobile communication device of a wireless communication system, comprising:
a high-frequency power amplifier (11) for amplifying an input power signal into an output power signal with a control terminal for controlling the high-frequency output power (Pₒᵤₜ) of the same,
a detection means (14) connected to an input line supplying said input power signal to the power amplifier (11) for detecting a value related to an actual value of said high-frequency output power (Pₒᵤₜ) by measuring a value associated with the input impedance of the power amplifier (11), and for providing a signal (Vₐₚ) indicative of said actual value of the high-frequency output power (Pₒᵤₜ), and
a control means (15) comparing a reference signal (T_{XP}) indicative of a target value of said high-frequency output power (Pₒᵤₜ) to said signal (Vₐₚ) indicative of an actual value of said high-frequency output power (Pₒᵤₜ), and providing a control signal (V_{apc}) to said control terminal of said power amplifier (11) for adjusting the high-frequency output power (Pₒᵤₜ) of the same.

2. A power controlled high-frequency transmit power amplifier circuit according to claim 1,
**characterised in**
**that** the reflected portion (P_{refl}) of the power (Pᵢₙ) of a high-frequency signal applied to the input (12) of said power amplifier (11) forms said value associated with said input impedance.

3. A power controlled high-frequency transmit power amplifier circuit according to claim 1 or 2,
**characterised in**
**that** said signal (Vₐₚ) indicative of an actual value of said output power (Pₒᵤₜ) is a DC-like voltage or a DC-like current.

4. A mobile terminal for wireless telecommunication systems, comprising
a power controlled high-frequency transmit power amplifier circuit (10) according to one of the claims 1 to 3.
